# EUROPEAN PATENT SPECIFICATION

(11) **EP 0 329 929 B1**
(45) Date of publication and mention of the grant of the patent: **28.09.1994**
(21) Application number: 89100289.1
(22) Date of filing: 10.01.1989
(51) Int. Cl.: H01L 39/12, H01L 39/24

(54) **Improvements to the manufacturing processes of high magnetic susceptibility ceramic superconductors**
Herstellungsprozess von keramischen Supraleitern hoher magnetischer Suszebilität
Procédé de fabrication de supraconducteurs céramiques à haute susceptibilité magnétique

(30) Priority: 12.01.1988 IT 4752188
(43) Date of publication of application: 30.08.1989
(73) Proprietor: SELENIA INDUSTRIE ELETTRONICHE ASSOCIATE S.p.A., I-00131 Roma (IT); ISTITUTO NAZIONALE DI FISICA NUCLEARE, Roma (IT); Consorzio INFM, Genova (IT)
(72) Inventor: Sparvieri, Nicola, I-00136 Roma (IT); Celani, Francesco, I-00175 Roma (IT); Pace, Sandro, I-00040 Rocca Priora (IT); Messi, Roberto, I-00040 Rocca Priora (IT)
(74) Representative: Gustorf, Gerhard, Dipl.-Ing.

(56) References cited:
- SOLID STATE COMMUNICATIONS, vol. 64, no. 8, November 1987, pages 1137-1140, Pergamon Journals Ltd, Oxford, GB; Z. GABELICA et al.: "Synthesis parameters affecting the bulk composition and superconducting properties of YBaCuO-based compounds"
- APPLIED PHYSICS LETTERS, vol. 51, no. 8, 24th August 1987, pages 619-621, American Institute of Physics, New York, US; D. DIJKKAMP et al.: "Preparation of Y-Ba-Cu oxide superconductor thin films using pulsed laser evaporation from high Tc bulk material"
- Lehrbuch der Anorganischen Chemie, Berlin 1971, Walter De Grüyter & Co., Holleman-Wiberg, p.269

## Description

The invention presented regards a process for the manufacturing of ceramic superconductors.

It is a well known fact that one is always posed with problems when achieving:
- material time stability
- high percentage of the superconductive phase present for T ≅ 77 K;
- high value of the critical current.

The document Solid State Communications, vol. 64, no. 8, November 1987, pp. 1137-1140, Gabelica et al. discloses the manufacturing of ceramic superconductors in air which usually has a very small ozone content. According to Appl. Phys. Lett., vol. 51, no. 8, August 1987, pp. 619-621, D. Dijkkamp et al., fragments of O, O₂, O₃ can be detected during a pulsed laser evaporation process.

The purpose of this invention is that of obtaining ceramic superconductors with improved superconduction efficienty and high mechanical and physical stability in the bulk state and improved thin and thick film surface.

Such problems are solved by the process, which is dealt with by this invention, as improved superconductivity efficiency, high hardness and mechanical compactness in bulk state are achievable by means of traditional tooling, as described in the following.

The invention pertains to the field of ceramic technologies and production of thick and thin films, and more generally to electronic and/or electrotechnical systems and devices for the production, storage, transportation and transforming of energy and/or information, screening and/or production of magnetic fields.

The process is outlined according to the unique characteristics known to date of high critical temperature ceramic superconductors such as, for example, Y, Ba₂ Cu₃ O_{7-δ} which lack Oxygen.

By means of this new process, it has been possible to improve all characteristics of the material : electromagnetic and electromechanical, including in particular that of magnetic susceptibility.

The improvement is obtained by introducing, together with customary bi-atomic oxygen, also mono-atomic oxygen O and tri-atomic oxygen O₃ during the calcination period throughout the thermal cycle, as already described, and during the following possible sintering phase.

The method described is particularly effective when used with superconductive powder provided with hyperfine granulosity (50-60 nm), produced by pyrolysis with citrates, and also when treating the surface of thin and/or thick films.

Monoatomic and tri-atomic oxygen are produced by an ozone generator at a rate greater than 25 cc/h in ozone (ozone efficiency preferably 4%). Such value is enough for 10 grams of superconductor material.

Monoatomic and tri-atomic gases released together with normal O₂, are suitably directed (preferably by means of an alumina pipe) into the crucible, possibly non-polluting, which contains the powders or films to be processed. The crucible is placed within an oven where the temperature may be varied with continuity between +30° C and +960° C.

The most significant feature of this invention is the preparation method, by which ceramic superconductors may be obtained with simultaneous high critical temperature (≧ 90K), almost ideal diamagnetic characteristics for magnetic fields greater than those noted for samples prepared with other methods, good mechanical properties.

Confirmation of the stability of superconductors produced by such method in the long term (years) and high current density values would make likely a substantial revolution in the area of electrotechnical, electronic and magnetic equipment presently utilized for civilian, strategic and research purposes.

The process consists of placing the sample in an atmosphere with high content of ozone and/or mono-atomic oxygen together with traditional bi-atomic oxygen during the calcination and possible sintering phase, starting from ambient temperature up to 960° C and viceversa, in accordance with the following thermal profile:
T ambient 960° C, 2^{h} ≦ t ≦ 10^{h}; 960° constant for 10 (ten) hours; 960° C T ambient - 50° C/h.

The ceramic superconducter manufacturing process assures greater superconductor efficiency, high degree of bulk mechanical hardness and compactness so as to allow for tooling by means of traditional facilities (lathe, router etc.).

## Claims

1. Process of manufacturing high critical temperature ceramic superconductors within an oxygen atmosphere containing O, O₂ and O₃, characterised by the deliberate addition of O and O₃ during the calcination and/or the following sintering phase, starting from ambient temperature up to a maximum temperature of 960°C for a time between 2 and 10 hours, maintaining said maximum temperature for 10 hours and then cooling down to the ambient temperature at a rate of 50°C/h.

2. Process as claimed in claim 1, wherein O and O₃ are produced by a generator at a rate greater than 25 cm³/h ozone and at an ozone efficiency of preferably 4% for 10g of superconductor material.

## Patentansprüche

1. Verfahren zur Herstellung von keramischen Supraleitern hoher kritischer Temperatur in einer O, O₂ und O₃ enthaltenden Sauerstoff-Atmosphäre, gekennzeichnet durch die absichtliche Zugabe von O und O₃ während der Kalzinationsphase und/oder der folgenden Sinterphase, wobei in einem Zeitraum von 2 bis 10 Stunden eine Erwärmung von Umgebungstemperatur auf eine Maximaltemperatur von 960°C erfolgt, welche 10 Stunden gehalten wird, wonach eine Abkühlung von 50°/h auf die Umgebungstemperatur erfolgt.

2. Verfahren nach Anspruch 1, dadurch gekennzeichnet, daß für 10g Supraleitmaterial von einem Generator O und O₃ mit einer Mengenrate von mehr als 25cm³ Ozon und einem Ozonanteil von vorzugsweise 4 % erzeugt wird.

## Revendications

1. Procédé de fabrication de supraconducteurs céramiques à température critique élevée dans une atmosphère d'oxygène contenant O, O₂ et O₃, caractérisé par l'addition délibérée de O et O₃ au cours de la phase de calcination et/ou de la phase de frittage qui vient à la suite, en passant de la température ambiante à la température maximale de 960°C en un temps valant entre 2 et 10 heures, en maintenant à ladite température maximale pendant 10 heures puis en refroidissant jusqu'à la température ambiante à la vitesse de 50°C/h.

2. Procédé comme revendiqué dans la revendication 1, dans lequel O et O₃ sont produits par un générateur à un débit supérieur à 25 cm³/h d'ozone et à un rendement en ozone de préférence de 4% pour 10g de matériau supraconducteur.
